# EUROPEAN PATENT SPECIFICATION

(11) **EP 2 154 572 B1**
(45) Date of publication and mention of the grant of the patent: **03.05.2017**
(21) Application number: 09166007.6
(22) Date of filing: 21.07.2009
(51) Int. Cl.: G03F 7/18, B41F 27/00

(54) **Process for making a cylindrically-shaped photosensitive element for use as a printing form**
Verfahren zur Herstellung eines zylinderförmigen lichtempfindlichen Elements zur Verwendung als Druckform
Procédé pour la fabrication d'un élément photosensible de forme cylindrique pour une utilisation en tant que forme d'impression

(30) Priority: 15.08.2008 US 189102 P
(43) Date of publication of application: 17.02.2010
(73) Proprietor: E. I. du Pont de Nemours and Company, Wilmington, DE 19805 (US)
(72) Inventor: Daiber, Bern, 63303 Dreieich (DE); Riechert, Stephan, 60599 Frankfurt (DE)
(74) Representative: de Bresser, Sara Jean

(56) References cited:
- WO-A1-2005/111725
- WO-A2-02/072353
- GB-A- 551 180
- US-A1- 2003 157 285
- US-A1- 2006 249 239

## Description

### BACKGROUND OF THE INVENTION

### 1. Field of the Disclosure

This invention pertains to a process for making a cylindrically-shaped photosensitive element for use as a printing form, in particular for use as a relief printing form.

### 2. Description of Related Art

Flexographic printing plates are well known for use in printing, particularly on surfaces which are soft and easily deformable, such as packaging materials, e.g., cardboard, plastic films, etc. Flexographic printing plates can be prepared from photopolymerizable compositions, such as those described in U.S. patents 4,323,637 and 4,427,749. The photopolymerizable compositions generally comprise an elastomeric binder, at least one monomer and a photoinitiator. Photosensitive elements generally have a photopolymerizable layer interposed between a support and a coversheet or multilayer cover element. Upon imagewise exposure to actinic radiation, polymerization, and hence, insolubilization of the photopolymerizable layer occurs in the exposed areas. Treatment with a suitable solvent removes the unexposed areas of the photopolymerizable layer leaving a printing relief which can be used for flexographic printing.

Photopolymerizable materials can be formed into sheets or layers by several known methods such as solvent casting, hot pressing, calendering and extrusion. A preferred method of forming photopolymerizable materials for use as flexographic printing elements is by extrusion calendering the photopolymerizable material. In extrusion calendering, the printing element is prepared by passing a mass of hot photopolymerizable material into an extrusion die forming a layer, passing the layer into the nip of a calender and, while still hot, calendering the photopolymerizable material between two flat surfaces, generally two flexible films, to form a multilayer web. The films can include multiple layers or compound films. After extrusion and calendering at elevated temperatures, the web can be held in tension while the multilayer web is cooled, for example, with blown air. The printing element as a multilayer web can be cut into suitable size sheets. Extrusion and calendering of a polymeric compositions are disclosed, for example, in Gruetzmacher et al., U.S. Patent 4,427,759.

Although typically photopolymerizable printing elements are used in sheet form, there are particular applications and advantages to using the printing element in a continuous cylindrical form. Continuous printing elements have applications in the flexographic printing of continuous designs such as in wallpaper, decoration and gift wrapping paper, and tight-fit conditions for registration, since the designs can be easily printed without print-through of the plate seam. Furthermore, such continuous printing elements are well-suited for mounting on laser exposure equipment where it can replace the drum or be mounted on the drum for exposure by a laser to achieve precise registration. In addition, registration of multicolor images is greatly enhanced and facilitated by mounting cylindrically-shaped printing forms on a printing press.

The formation of seamless, continuous printing elements can be accomplished by several methods. The photopolymerizable flat sheet elements can be reprocessed by wrapping the element around a cylindrical form, usually a printing sleeve support or the printing cylinder itself, and then heating to join the edges together to form a seamless, continuous element. Processes for joining the edges of a plate into a cylindrical form have been disclosed, for example, in German patent DE 28 44 426, United Kingdom patent GB 1 579 817, European patent application EP 0 469 375, U.S. Patent 4,883,742, and U.S. Patent 4,871,650. These processes can take extended periods of time to completely form the cylindrical printing element since the sheet is heated after wrapping to bring the sheet up to a temperature to join the edges.

In particular, U.S. Patent 4,883,742 discloses seamless and firm joining of the end and/or lateral areas of thermoplastically processible photosensitive layers by overlapping the ends and/or areas to avoid bubbles and entrapment of air in between. The total layer material is heated under pressure and with joining of overlapping ends/areas resulting in a continuously joined photosensitive layer. In many methods of forming the continuous photosensitive element, the continuously joined photosensitive layer is typically ground to provide the desired thickness uniformity of the photopolymer layer and surface characteristics for the printing form.

Further, photosensitive resin cylinders are also made from a layer of photopolymeric composition by a Seamex process. The Seamex process involves wrapping a layer of photopolymeric material to a nickel sleeve having a heat-activated primer coat to bond with the material so that the ends of the plate are joined together. The entire assembly is placed in an oven to cure and bond the photopolymeric layer to the primer coat and melt ends of the photopolymeric layer together. The photopolymeric layer on the sleeve is then ground to the necessary thickness, wiped clean and sprayed with a protective coating to prevent negatives from sticking to the photopolymer during exposure. However, the process of wrapping, curing and melting, grinding and spraying the photopolymeric layer to the sleeve takes about 1.5 to 2 days to accomplish.

U.S. Patents 5,798,019 and 5,916,403 disclose an apparatus and a process for forming a cylindrical photosensitive element of uniform thickness on a flexible sleeve without sanding, grinding or additional polishing steps. The method involves supplying a stream of molten photopolymerizable material onto the sleeve supported directly on a mandrel, calendering the molten photopolymerizable material to have a substantially constant thickness on the sleeve, moving the sleeve around and along the mandrel in a helical fashion to polish an outer surface of the element, and during the calendering step, heating the photopolymerizable material. In a first mode, the flexible sleeve is mounted on an air lubricated mandrel such that the air permits the rotational and axial movement of the flexible sleeve, and the stream of molten photopolymerizable material is fed into a gap between the sleeve and a calender roll. In a second mode, the flexible sleeve is mounted onto a mandrel with the calender rolls positioned around the sleeve at the predefined clearance. A solid sheet of photopolymerizable material is fed into the gap between the sleeve and the calender roll. Once there is coverage of the photopolymerizable material around the circumference of the sleeve, the contact of the photopolymerizable material with the calender rolls will rotate the sleeve. During calendering, the solid sheet is heated beyond its glass transition temperature to permit metering of the sheet. However, this process requires considerable capital investment in equipment to provide the variety of sizes (e.g., inside diameters or repeat lengths, and widths of printing form) to accommodate the needs of the printing industry.

U.S. Patent 6,425,327 discloses a method for forming a cylindrical photosensitive element on a cylindrical sleeve wherein the flexible sleeve is mounted onto a sleeve support. The sleeve support isolates the flexible sleeve from high temperature and/or high pressure associated with forming a cylindrical photosensitive layer from a molten photopolymerizable material on the flexible sleeve. The sleeve support can be used alone or in combination with a mandrel. The sleeve support is substantially rigid and thermally stable so not change dimension or distort or change shape while supporting the flexible sleeve. No mention is made of particular surface characteristics of the sleeve support.

A problem sometimes arises in that bubbles can form while joining the ends of a solid photosensitive layer wrapped onto a sleeve. Bubbles can cause differences in the compressibility of the continuous printing form resulting in differences in ink-transfer during printing. Bubbles, or air entrapment, between the photopolymer layer and the sleeve support can result in loss of adhesion of the photopolymer to the sleeve. Impression on press during printing can cause the bubbles to become larger such that the photopolymer layer may lift in part or in whole from the continuous printing form. It is also possible that bubbles in the photopolymer layer can materialize on an exterior surface of the photopolymer layer after grinding. Bubbles on the exterior surface of the photopolymer layer can cause non-uniformities in printing areas resulting in missed printing, and/or poor print quality.

WO 2005/111725 discloses a method of making a photopolymer sleeve blank having an integral cushion layer for flexographic printing.

US 2006/0249239 discloses methods for producing seamless flexographic printing elements.

WO 02/072353 discloses a flexographic device with associated thermally addressable mesh.

GB 651,180 discloses methods of mounting printing plates on supports.

Thus, there is a need for an easy, relatively quick and productive method for making cylindrically-shaped photosensitive elements. The method should be capable of making cylindrically-shaped photosensitive elements without defects such as bubbles.

### SUMMARY OF THE INVENTION

The present invention provides a process for making a cylindrically-shaped photosensitive element for use as a printing form, comprising:
a) mounting a cylindrically-shaped support (12) having an exterior surface (18) and an interior surface onto a roll (11) having an outer surface (21), the interior surface of the support (12) contacting the outer surface (21) of the roll (11), wherein the roll (11) is selected from a shaft, a drum or a mandrel and wherein the outer surface (21) of the roll (11) is compliant;
b) providing a photosensitive layer (20) comprising a thermoplastic binder, monomer and photoinitiator, the layer having a first end (25) and a second end (35) opposite the first end (25) joined by a contact surface (34);
c) contacting the contact surface (34) of the photosensitive layer (20) to the exterior surface (18) of the support (12) by wrapping the photosensitive layer (20) around the support (12) to bring the second end (35) adjacent the first end (25);
d) laminating the photosensitive layer (20) onto the support (12) and sealing the ends (25, 35) together to form a continuous layer (20) on the support (12); and
e) heating the photosensitive layer (20), or the support (12), or both the photosensitive layer (20) and the support (12); characterised in that the photosensitive layer (20) is laminated onto the support (12) by using a laminating roll (14) to form a nip with the support (12) and the photosensitive layer (20) therebetween and the process further comprises the step of removing the resulting cylindrical photosensitive element from the base roll.

### BRIEF DESCRIPTION OF THE DRAWINGS

Figure 1 is a schematic side view of one embodiment of a process for making a cylindrically shaped photosensitive element, that includes one embodiment of a step of providing a cylindrically-shaped support mounted onto a roll having an outer surface that is compliant, and providing a layer of a photosensitive composition between a laminating roll and the roll.
Figure 2 is a schematic side view of one embodiment of a step in the process of the present invention showing heating the photosensitive layer and the support.
Figure 3 is a schematic side view of one embodiment of a step in the process of the present invention showing contacting the photosensitive layer onto the support.

### DESCRIPTION OF THE PREFERRED EMBODIMENT(S)

Throughout the following detailed description, similar reference characters refer to similar elements in all figures of the drawings.

The present invention provides a process for making a cylindrically-shaped photosensitive element for use as a printing form. In some embodiments the printing form is particularly suited for relief printing, including use as a flexographic printing form and letterpress printing form. Relief printing is a method of printing in which the printing form prints from an image area, where the image area of the printing form is raised and the non-image area is depressed. In some embodiments, the printing form is suited for gravure or gravure-like printing. Gravure printing is a method of printing in which the printing form prints from an image area, where the image area is depressed and consists of small recessed cups or wells to contain the ink or printing material, and the non-image area is the surface of the form. Gravure-like printing is similar to gravure printing except that a relief printing form is used wherein the image area is depressed and consists of recesses areas forming wells to carry the ink which transfer during printing. The process is quick, providing a cylindrically shaped photosensitive element from a formed layer of photosensitive composition in minutes, versus days required by other methods. The process is easy, securely providing the photosensitive layer directly on the cylindrical support avoiding a step to apply an adhesive material to the support and associated potential for defects in the applied adhesive layer and in the resulting cylindrical printing form. The process can optionally also avoid using a cylindrically-shaped support having an exterior surface that needs to be treated to promote adhesion of the photosensitive layer to the support. The process reduces the potential for defects, such as bubbles, forming in the photosensitive layer during contacting and laminating to join the adjacent ends of the layer. The photosensitive element is adapted after imagewise exposure and treatment to become a cylindrical printing element having a surface suitable for printing. In some embodiments the surface is a relief surface suitable for relief printing. In some embodiments, the surface is an ink receptive cell surface, suitable for gravure or gravure-like printing.

The process includes providing a cylindrically-shaped support having an exterior surface and an interior surface opposite the exterior surface. The interior surface of the cylindrically-shaped support is adjacent an outer surface of a roll, of which the outer surface is compliant. The roll may be a base roll associated with a device for forming the cylindrically-shaped photosensitive element, or may be an adapter mounted onto the base roll. The adapter may have a slip fit or an interference fit on the base roll. In some embodiments, a layer of a compliant material forms the outer surface on the base roll. In other embodiments, a layer of compliant material forms the outer surface on the adapter. In yet another embodiment, the adapter on the base roll may be formed of a compliant material to provide the desired compliancy to the outer surface of the roll.

The layer forming the outer surface of the roll can be composed of any material suitable to provide a compliant supporting outer surface for the cylindrically-shaped support during lamination. The compliant outer surface of the roll yields elastically when a force is applied during lamination and allows air to escape as the ends of the photosensitive layer are being sealed to thereby avoid trapping air and forming bubbles in the photopolymerizable layer. The compliant outer surface is sufficiently elastic that it retains or substantially retains its original shape once the force is removed. In most embodiments, it is also desirable that the outer surface of the roll is sufficiently resilient so the outer surface is capable of withstanding the force without permanent or deformation or rupture. Suitable resiliency of the layer extends the operational life of the roll, reducing the need to replace the roll or the outer surface of the roll should the layer on the outer surface loose its compliancy. The compliant outer surface on the roll can result in a longer contact zone at a nip between a laminating roll and the roll as a result of the compliant outer surface deflecting under the pressure exerted by the laminating roll. The compliant outer surface of the roll should be resistant to heat and deformation at the temperatures at which the laminating and heating steps are conducted.

In some embodiments, the layer forming the compliant outer surface on the roll can be composed of any material suitable to provide a durometer between about 40 and about 70 Shore A. Examples of suitable materials include, but are not limited to, natural rubbers, synthetic rubbers, natural elastomeric materials, synthetic elastomeric materials, and compressible foams. In some embodiments, the compliant outer surface is a layer of rubber or silicone rubber. In some other embodiments, the compliant outer surface is a layer of compressible foam. In yet other embodiments, the compliant outer surface is a layer of open-cell foam. Compressible foams include sponges and foams, such as polyurethane foams, polyolefin foams, polyvinyl chloride foams, rubber foams, and the like. The foam may be open- cell or close-cell foam. The foams can be chemically blown or mechanically frothed with any gas, including air, provided that it does not substantially detract from the desired compliance of the foam. The compliant layer can include additives such as metal particles, and reinforcing fibers to provide desired characteristics to the surface of the roll. In some embodiments in which the compliant material forms a layer on the base roll or the adapter, the layer has a thickness that can range from 0.1 to 10 mm (0.004 to 0.4 inch). In some other embodiments, the compliant layer has a thickness greater than 7 mm (0.28 inch).

A suitable method for determining the Shore A durometer is by standard test method ASTM D2240-05 or DIN 53,505. Note that although the ASTM D2240-05 standard recites that a test specimen (of the compliant material) should have at least 6.0 mm (0.24 in.) thickness, the test is conducted on the thickness of the layer of compliant material as it exists on the roll, and as such the compliant layer may be thinner (or thicker) than the recommended test specimen thickness. The test is performed at standard room conditions in a room having between 40-60% relative humidity and at a temperature between 15 to 18°C. The instrument that measures Shore A durometer is an indentor, which can be an operated in stand or manual (hand held) mode.

When mounted on press, the interior surface of the cylindrically-shaped support is adjacent an outer surface of a print cylinder or a bridge adapter mounted onto the print cylinder. The cylindrically-shaped support, which may also be referred to herein as a sleeve, or base sleeve, or sleeve support, carries the photosensitive layer and provides the cylindrical element with the capability to be readily mounted and dismounted from the print cylinder and the roll. The sleeve should be able to grip the roll without rotational slippage. The sleeve, as part of a cylindrically-shaped printing form should also be able to grip the print cylinder without slippage. The sleeve can be held on the roll without slippage by any means, including friction fit or interference fit. The fit used to hold the sleeve to the roll can be the same or different than the fit used to hold the sleeve to the print cylinder. For friction or slip fit, the sleeve is slid onto the roll (or print cylinder) and held in position by friction between an interior surface of the sleeve and the outer surface of the roll (or print cylinder). In some embodiments, the roll has an outer diameter that is less than an inner diameter of the sleeve support, so that the support can slide onto the roll and be held for rotation by friction between the sleeve and the roll. For interference fit, the sleeve should be expandable typically with 20 to 100 psig (140 to 690 kPag) air generally available in printing facilities. The sleeve should expand sufficiently for it to easily slide over the roll (or print cylinder), so that an expansion exceeding the amount of interference fit is required. A typical interference fit with a base roll or the print cylinder is 3 to 15 mils (75 to 375 *µ*m), but is not so limited. In some embodiments, the sleeve is mounted onto the roll and held using a friction fit. In other embodiments, the sleeve is mounted on the roll and held using interference fit. In most embodiments interference fit is suited to securely mount the cylindrical printing form onto the print cylinder.

Provided that the sleeve support can be mounted on the roll and the print cylinder with appropriate fit, the material/s and structure/s used to form the sleeve is not particularly limited. The sleeve can be formed of any material or combination of materials conventionally used in forming sleeves for printing. The sleeve can have a single layer, multi-layer, composite, unitary structure. The sleeve should be constructed such that it is homogeneous regarding flexibility, durometer, etc., but can include elements such as small strips or filaments for stabilization provided that such elements do not influence the capability of the continuous printing form to print. In some embodiments, the sleeve includes a layer of a resin composition that forms at least the exterior surface of the sleeve support. In some embodiments, the support is formed of one or more layers of material and includes as its exterior surface a layer of the resin composition. In some embodiments the support is formed entirely of a layer of the resin composition. In some embodiments the support is formed of a resin composition having fillers and/or fibers. The support formed of a resin composition reinforced with fiber is an example of a composite sleeve. In some embodiments the support is formed of one or more layers of resin composition that can be the same or different. Materials suitable as the resin composition are not limited, provided that the layer of resin does not melt or flow upon preheating to attach the photosensitive layer to the sleeve support. Examples of suitable resin materials include epoxy resins; polystyrene and polyvinyl resins, such as polyvinyl chloride and polyvinyl acetate; phenolic resins; and aromatic amine-cured epoxy resins. In some embodiments the resin may include fillers or can be fiber reinforced. The fibers used in the resin composition are not limited and can include, for example, glass fibers, aramid fibers, carbon fibers, metal fibers, and ceramic fibers. Fibers incorporated with the sleeve can include continuous, woven, and/or wound materials. An example of a suitable sleeve is described in U.S. 6,703,095. In one embodiment the sleeve support is selected from the group consisting of a fiber-reinforced polymeric resin or plastic. In some embodiments, the sleeve support is transparent to ultraviolet radiation to accommodate backflash exposure for building a floor in the cylindrical printing form. The sleeve has a (wall) thickness from about 0.01 and about 6.35 mm or more. In some embodiments, the sleeve has a thickness between about 0.25 and 0.75 mm. In some embodiments the sleeve has a thickness between about 0.30 and 0.70 mm. In some embodiments the sleeve has a thickness between about 0.60 and 0.80 mm. In some embodiments, the sleeve has a thickness between about 1 and 3 mm. In some embodiments, the sleeve includes a layer of a resin composition as its exterior surface that has a thickness between 0.05 and 0.09 mm.

Other materials also suitable for use as the sleeve support or in combination with sleeve made of the resin composition as described above include those materials that are conventionally used as a support for photosensitive elements used to prepare printing plates. The sleeve may be formed from single layer or multiple layers of flexible material. Examples of suitable flexible materials for use in the sleeve include polymeric films, such as those formed by addition polymers and linear condensation polymers, and foams and fabrics, such as fiberglass. In some embodiments flexible materials are transparent to ultraviolet radiation to accommodate backflash exposure for building a floor. The sleeve support may also include non-transparent, actinic radiation blocking materials, such as nickel or glass epoxy. Under certain end-use conditions, metals such as aluminum may also be used as a layer in the support, even though a metal support is not transparent to radiation. Multiple layered sleeves may include an adhesive layer or tape between the layers of flexible material, such as disclosed in U.S. Patent 5,301,610.

Optionally, the cylindrically-shaped photosensitive element can include an adhesive layer between the support and the photosensitive layer, or the exterior surface of the support has an adhesion-promoting surface. In some embodiments, the exterior surface of the sleeve may include an adhesive material or tape. The adhesive layer on the surface of the support can be a subbing layer of an adhesive material or primer or an anchor layer as disclosed in U.S. Patent 2,760,863 to give strong adherence between the support and the photopolymerizable layer. The adhesive compositions disclosed by Burg in U.S. Patent 3,036,913 are also effective. Alternatively, the exterior surface of the support can be treated to promote adhesion between the support and the photosensitive layer, with flame-treatment or electron-treatment, e.g., corona-treated.

The process includes the step of providing a layer of a photosensitive composition. Any thermoplastically processible solid photosensitive layer that can be joined to itself under the influence of heat and pressure without its photosensitive properties being adversely affected are suitable for use. This include, in particular, the solid, polymeric, photosensitive layers which soften on heating or exhibit adhesive bonding under pressure as known per se for the production of printing relief plates. The solid photosensitive layer includes at least a thermoplastic binder, monomer, and photoinitiator. As used herein, the term "solid" refers to the physical state of the layer that has a definite volume and shape and resists forces that tend to alter its volume or shape. The photosensitive layer is generally considered a solid at room temperature.

The photosensitive layer can be sheet-like, belt-like, or strip-like. In one embodiment, the photosensitive layer to be used according to the invention may be unsupported in order to permit firm contact attachment with the sleeve and fusing of the ends and/or lateral areas of the photosensitive layer with formation of a continuous homogeneous layer. Some embodiments use a self-supporting photosensitive layer. In some embodiments it is also possible for the photosensitive layer used to first be applied to a temporary support for example a plastic film, which is then removed, for example, by peeling it off, directly before the photosensitive layer is used in the process.

In some embodiments the layer of photosensitive composition may originate from a photosensitive element suitable for use as a printing plate, that is, the element may include at least a flexible (sheet) support, the photosensitive layer, a release layer on the photosensitive layer, and a coversheet. In some embodiments, the sheet support includes a silicon-based surface or layer that promotes easy release from the photosensitive layer. In some embodiments the layer of photosensitive composition may originate from a photosensitive layer formed between two sheet supports having the silicon-based surface or layer. One or more additional layers, e.g., elastomeric cap layer, may be included in the element that can transfer with the photosensitive layer to the cylindrical support. At least the sheet support or the coversheet (as well as the release layer) are removed from a side of the photosensitive layer that will be adjacent the exterior surface of the sleeve support, prior to heating of the photosensitive layer or prior to contact of the photosensitive layer to the support. The sheet support or the coversheet (and release layer) that remains can be removed in some embodiments prior to contacting, or prior to laminating, and in other embodiments removed after contacting the photosensitive layer to the sleeve support. In some embodiments the provided photosensitive layer has a thickness that is equal to or greater than a thickness of the continuous photosensitive layer formed on the sleeve.

The photosensitive layer includes a first end and a second end generally opposite the first end that are joined by a contact surface. The first end and the second end may be any ends of the layer of photosensitive composition that when wrapped about the cylindrical support, can at least be adjacent to one another in order to form the layer into a cylinder. In some embodiments, the first end and the second end may be distal ends. In some embodiments, the first end and the second end may be lateral ends or edges. The photosensitive layer need not be cut exactly to size. The layer can be cut such that when the layer is wrapped on the sleeve the first end and the second end are adjacent. In some embodiments, the first end and the second end are considered adjacent if the first end and the second end mate or abut against each other. In some other embodiments, the first end and the second end are considered adjacent if the first end and the second end form a small gap (e.g., about 0.5 to 1 mm, or up to about half of the thickness of the photosensitive layer). The layer can be cut to any desired shape including, for example, square, rectangular, trapezoidal, and in the form of a parallelogram. The ends that will at least be adjacent when cylindrically oriented may be trimmed or may be trimmed to mate with each other. One or both of the ends can be trimmed. The adjacent ends can be trimmed prior to (pre)heating the photosensitive layer, or prior to contacting of the photosensitive layer and the support. The adjacent ends may be perpendicular or at an angle relative to a planar surface (i.e., the contact surface or exterior surface) of the photosensitive layer. The adjacent ends may be trimmed to have a beveled, chamfered, or wedge-shape. The contact surface of the photosensitive layer is the surface of the layer that comes in direct contact with the exterior surface of the cylindrically-shaped support. The photosensitive layer includes an exterior surface opposite the contact surface.

Optionally, the photosensitive layer may be overall exposed to actinic radiation to form a floor of a shallow layer of polymerized material in the layer, prior to heating. Overall exposure to form a floor is often referred to as a backflash exposure. In an embodiment where the photosensitive layer is backflash exposed prior to contacting the layer to the support, the backflash exposure is given to the contact surface of the photosensitive layer since the floor that is formed will be adjacent to the support. In some embodiments, the backflash exposure occurs after the sheet support (if present) is removed from the contact surface of the photosensitive layer. In other embodiments, the backflash exposure occurs before the sheet support (if present) is removed from the contact surface of the photosensitive layer. Back flash time can range from a few seconds to about 10 minutes. The backflash exposure can sensitize the photosensitive layer, help highlight dot resolution and also establish the depth of relief for the printing form. The floor provides better mechanical integrity to the photosensitive element. In some embodiments, the backflash exposure can occur after the cylindrically-shaped photosensitive element is formed provided that the cylindrical support is transparent to the actinic radiation. In this instance the exposure to form the floor may also improve adhesion of the photosensitive layer to the support.

The process includes heating the sleeve support and/or the photosensitive layer. In one embodiment, the heating step can be a preheating of the sleeve support and/or the photosensitive layer wherein the heating occurs prior to contacting the support and the photosensitive layer. In one embodiment, the sleeve support and/or the photosensitive layer is preheated to a temperature sufficient to effect the attachment of the photosensitive layer to the sleeve support without the need for any adhesive material or tape on the exterior surface of the support. It is unexpected that preheating the cylindrically-shaped support and/or photosensitive layer is sufficient to adhere the photosensitive layer onto the support. It is unexpected and surprising that preheating the support and/or the photosensitive layer prior to contact of the layer and support provides sufficient heat to at least seal the ends of the layer together and form continuous layer on the support. It is unexpected and surprising that preheating the support and/or the photosensitive layer prior to contact of the layer and support can provide sufficient heat to seal and fuse the ends of the layer together and form a continuous layer on the support. The exterior surface of the sleeve support and/or the contact surface of the photosensitive layer is preheated to assure that the two surfaces are capable of attaching upon contacting due to the tacky nature of the thermoplastic photosensitive layer. In other embodiments, the sleeve support and/or the photosensitive layer is preheated to a temperature sufficient to aid the attachment of the photosensitive layer to the sleeve support having an adhesive material or tape on the exterior surface of the support. Preheating is performed prior to the contacting of the photosensitive layer and the sleeve. It should be understood that preheating of the exterior surface and/or the contact surface can occur on portions of the sleeve and/or layer that are not yet contacted while other portions of the sleeve and layer are contacted together.

In some embodiments the exterior surface of the sleeve support is only preheated to a temperature sufficient to attach, or bond, or join the photosensitive layer to the sleeve, but not so high as to cause the sleeve to distort or deform or degrade. In some embodiments, the exterior surface of the sleeve is preheated to a temperature greater than 39°C to attach the photosensitive layer to the sleeve support. In some embodiments, preheating of the exterior surface creates a heat sink-like effect in the sleeve, rendering the sleeve capable of transferring heat from the sleeve to the photosensitive layer during contact of the photosensitive layer with the sleeve, and causing the photosensitive layer to become sufficiently tacky to attach to the sleeve. In some embodiments, preheating the exterior surface of the sleeve heats the entire sleeve support through in depth (i.e., through entire wall thickness to interior surface). In other embodiments, preheating the exterior surface of the sleeve heats only the surface or a partial depth of the wall thickness of the sleeve. Preheating the exterior surface of an embodiment of the sleeve that is composed of a resin composition to greater than 39°C enables the photosensitive layer to attach to the support. In some embodiments the exterior surface of the sleeve can be heated between 40°C and 75°C. In some embodiments the exterior surface of the sleeve can be heated between 40°C and 95°C. In some embodiments the exterior surface of the sleeve can be heated between 40°C and 105°C.

In some embodiments only the contact surface of the photosensitive layer is preheated to a temperature less than the glass transition temperature of the photosensitive layer which is sufficient to attach or bond or join the photosensitive layer to the support with or without the need for any adhesive material or tape between the support and layer. In some embodiments, preheating of the contact surface causes the photosensitive layer to become sufficiently tacky to attach to the exterior surface of the sleeve. In some embodiments, preheating the contact surface of the photosensitive layer heats the entire layer through in depth thickness. In other embodiments, preheating the contact surface of the photosensitive layer heats only the contact surface or a partial depth of the thickness of the layer. Heating the contact surface of the photosensitive layer to less than its glass transition temperature enables the photosensitive layer to attach to the support or to seam to form a continuous layer, without causing the layer to flow or melt. It is desirable to avoid heating the photosensitive layer to a temperature that causes the thermoplastic material to melt or flow since this can cause thickness nonuniformity of the layer. In some embodiments, the contact surface of the photosensitive layer can be heated between 40°C and 100°C. In some embodiments the exterior surface of the sleeve can be heated between 40°C and 75°C. In some embodiments the exterior surface of the sleeve can be heated between 40°C and 65°C. In some embodiments the exterior surface of the sleeve can be heated between 40°C and 55°C.

Both the exterior surface of the sleeve support and the contact surface of the photosensitive layer can be preheated prior to contacting the support and the photosensitive layer. In some embodiments, the exterior surface and the contact surface are both preheated to the same or substantially the same temperature. In other embodiments, the exterior surface and the contact surface are both preheated to different temperatures. In other embodiments, the exterior surface of the sleeve is preheated to a temperature higher than a preheat temperature for the contact surface of the photosensitive layer. In other embodiments, the contact surface of the photosensitive layer is preheated to a temperature higher than a preheat temperature for the exterior surface of the sleeve. In some embodiments, the contact surface and the exterior surface are preheated to at least 40°C. In some embodiments, the contact surface and the exterior surface are preheated between 40°C and 100°C. In some embodiments, the exterior surface and/or the contact surface is preheated in 10 minutes or less. In some embodiments, the exterior surface and/or the contact surface is preheated in 5 minutes or less. In some embodiments, the exterior surface and/or the contact surface is preheated in 1 minute or less.

In other embodiments, the heating step can heat the sleeve support and/or the photosensitive layer after the support and the photosensitive layer are brought into contact. The sleeve support and/or the photosensitive layer is heated to assure that the photosensitive layer can form a continuous layer on the sleeve upon laminating due to the thermoplastic nature of the photosensitive layer. The sleeve support and/or the photosensitive layer is heated to a temperature sufficient to effect the attachment of the photosensitive layer to the sleeve support. The support roll may include means for heating such that sleeve support is heated. However, the sleeve support is only heated to a temperature sufficient to attach, or bond, or join the photosensitive layer to the sleeve, but not so high as to cause the sleeve to distort or deform or degrade. In some embodiments, the photosensitive layer can be heated between 40°C and 105°C. In some embodiments the sleeve can be heated between 40°C and 100°C. In some embodiments the sleeve can be heated between 40°C and 75°C.

Heating also includes combinations of pre-heating (prior to contact of the photosensitive layer to the sleeve support) and post-heating (after contact of the photosensitive layer to the sleeve support) the photosensitive layer and/or the sleeve in order to sufficiently attach or bond or join the photosensitive layer to the support.

The photosensitive layer melts or flows at the glass transition temperature. The material of the photosensitive layer is usually a viscoelastic material which does not have a sharp transition between a solid and a liquid, and thus the glass transition temperature may not have a sharp transition temperature between a solid and a liquid state. Heating of the photosensitive layer to less than its glass transition temperature avoids the viscoelastic material from flowing or melting. Heating the photosensitive layer to any temperature sufficient to cause the layer to soften and/or become tacky, but below the threshold to flow or melt, is suitable. In some embodiments, the photosensitive layer may be heated to a temperature at least 10°C lower than its glass transition temperature. In some embodiments, the photosensitive layer may be heated to a temperature at least 30°C lower than its glass transition temperature. In some embodiments, the photosensitive layer may be heated to a temperature at least 60°C lower than its glass transition temperature. In some embodiments, the photosensitive layer may be heated to a temperature at least 100°C lower than its glass transition temperature. However throughout this specification the term "softening" may be used to describe the behavior of the heated photosensitive layer, regardless of whether the composition may or may not have a sharp transition temperature between a solid and a liquid state. A wide temperature range may be utilized to "soften" the photosensitive layer for the purposes of this invention. Sealing as well as fusing of the ends may be slower at lower temperatures and faster at higher temperatures during successful operation of the process.

The support sleeve and/or the photosensitive layer can be heated by any suitable heating means including conduction, convection, radiation, and combinations thereof, to a temperature sufficient to effect the attachment of the photosensitive layer to the sleeve support or to effect the formation of a continuous layer of the photosensitive material on the sleeve. In some embodiments, the exterior surface and/or the contact surface can be quickly heated by a radiant energy source, such as an infrared heating lamp. One or more radiant energy sources can be used to preheat the contact surface and/or the exterior surface. In other embodiments, the support sleeve and/or the photosensitive layer can be heated by contact with a heated roll, preferably having a non-stick surface, that is brought into contact with the exterior surface of the support or with the contact surface of the photosensitive layer. In some embodiments, the support sleeve can be heated by the roll on which the sleeve is held. In some embodiments, the sleeve and/or the photosensitive layer can be rotated or transported in front of one or more heat sources that are stationary. In other embodiments, the heat source can be moved relative to the photosensitive layer and/or the exterior surface. A different source of heat or the same source of heat used to heat the sleeve can be used to heat the photosensitive layer.

The amount of time to heat the sleeve support and/or the photosensitive layer to a temperature suitable to attach the photosensitive layer to the sleeve support and seal, or seal and fuse, the ends is dependent at least on the sleeve composition, the photosensitive composition, the thickness of the sleeve, the thickness of the photosensitive layer, if one or both the sleeve and the photosensitive layer are heated, the method of heating, the proximity of the heat source to the exterior surface and/or contact surface, if the heating is conducted before and/or after contacting of the photosensitive layer and the sleeve support, etc.

The process includes contacting the contact surface of the photosensitive layer to the exterior surface of the support by wrapping the photosensitive layer around the support to bring the second end adjacent the first end. In some embodiments, contacting brings the photosensitive layer in contact with the sleeve support. In other embodiments contacting brings the photosensitive layer in contact with an adhesive material or tape on the sleeve support. A roll located adjacent the base roll is used for contacting the sleeve and the photosensitive layer to assure good contact and to assist the compliant layer with the removal of air between the sleeve and the layer, and thereby minimize air entrapment and the potential for bubbles. The roll, which may also be referred to as a laminating roll, forms a nip with the sleeve mounted on the base roll and the photosensitive layer therebetween. The laminating roll and/or the base roll include means for relative motion such that a distance between the exterior surface of the sleeve and the laminating roll at the nip, i.e., gap, can be changed to apply pressure at the nip to the photosensitive layer on the support. The base roll and/or the laminating roll may remain in a fixed position as the laminating roll and/or the base roll are moved to capture the photosensitive layer in between. In some embodiments, the laminating roll can have impression setting between 0 to 1 mm of displacement of the roll in the gap. An impression setting of 0 represents the distance at the nip being equal or substantially equal to the thickness of the photosensitive layer. An impression setting of 1 mm represents the distance at the nip being about 1 mm less than the thickness of the photosensitive layer. In some embodiments, the roll can have impression setting between 0 and 0.5 mm. The means for relative motion also can accommodate making cylindrically-shaped photosensitive elements having photosensitive layers with different thickness.

The photosensitive layer is contacted to the sleeve support by capturing the first end (a leading end) of the layer in the nip between the support mounted on a base roll and the laminating roll, rotating the base roll and laminating roll thereby contacting the exterior surface of the support with the contact surface of the photosensitive layer and wrapping the photosensitive layer onto the support. Since the laminating roll provides intimate contact or presses the photosensitive layer with the sleeve that is supported on the compliant outer layer of the roll, air does not become entrapped between the photosensitive layer and the support. In one embodiment the laminating roll at least provides intimate contact of the layer with the sleeve that is supported on the compliant outer layer of the roll. In other embodiments the laminating roll presses the photosensitive layer to the sleeve that is supported on the compliant outer layer of the roll. The base roll (with the support) rotates at least about 1 full revolution, i.e., 360 degrees, wrapping the photosensitive layer onto the support and bringing the first end and the second end at least adjacent one another. In some embodiments the base roll (with the support) rotates more than 360 degrees, to about 450 degrees, to securely bring the first and second ends at least adjacent one another. In some embodiments after the base roll has traveled at least about 360 degrees and the photosensitive layer is wrapped to contact the sleeve support, the first end and the second end are adjacent and abut against each other. In some embodiments after the base roll has traveled at least about 360 degrees and the photosensitive layer is wrapped to contact the sleeve support, the first end and the second end are adjacent and mate or abut with each other. In some embodiments after the base roll has traveled at least about 360 degrees and the photosensitive layer is wrapped to contact the sleeve support, the first end and the second end are adjacent and form a small gap with each other. In some embodiments, the gap is less than half the thickness of the photosensitive layer. In other embodiments the gap can be about 0.3 to 1 mm.

If the photosensitive layer originated from a photosensitive element for use as a printing plate, and the sheet support or the coversheet (and release layer) remained on an exterior surface of the photosensitive layer opposite the contact surface during contacting, the sheet support or the coversheet is removed after the roll has made a revolution to contact the ends and before fusing of the ends. In one embodiment, the coversheet or the sheet support can be removed as the base roll rotates through its first rotation after the photosensitive layer has contacted the support.

In some embodiments, preheating of the exterior surface and/or the contact surface and laminating can seal and fuse the adjacent ends together. In some embodiments, preheating of the exterior surface and/or the contact surface and laminating can seal the adjacent ends together, and additional heating may be needed to fuse the adjacent ends together. In some embodiments, heating the sleeve support and/or the photosensitive layer and laminating can seal and fuse the adjacent ends together. "Seal" or "sealing" of the adjacent ends of the photosensitive layer means that the adjacent ends are sufficiently held together to form a continuous layer on the support, but a line of demarcation, or a seam or joint where the adjacent ends met, is present. In most instances in this embodiment, the seam or joint in sealed adjacent ends will be visible on the exterior surface of the cylindrical photosensitive element. In other cases, the seam or joint in sealed adjacent ends will become apparent during printing. "Fuse" or "fusing" of the adjacent ends of the photosensitive layer means that the adjacent ends are held and bonded together to form a continuous layer on the support, such that a line of demarcation, or a seam or joint where the adjacent ends met, is not present. After laminating and fusing, the photosensitive layer becomes a continuum of photosensitive material and the cylindrical photosensitive element can be considered seamless.

In some embodiments, after contact of the photosensitive layer with the sleeve, the layer and/or the sleeve is no longer heated by the means for preheating as described above. The preheating of the exterior surface and/or the contact surface is sufficient to cause the photosensitive layer to become or maintain its tacky nature to attach to the sleeve, and to soften sufficiently to seal and fuse the adjacent ends together. It is surprising that preheating of the exterior surface of the sleeve support and/or the contact surface of the photosensitive layer is not only capable of attaching the layer to the sleeve without the need for an adhesive or tape, but is also sufficient the adjacent ends to seal and fuse together during laminating.

In some embodiments of preheating, after contact of the photosensitive layer with the sleeve, cylindrical photosensitive element is additionally heated by a means for heating. The preheating means for the exterior surface and/or the contact surface described above can also operate as the additional means for heating. The means for preheating may need to be oriented appropriately to function as the additional means for heating. Alternatively, the additional means for heating can be independent of the preheating means. The additional means for heating is not limited and can include conduction, convection, and radiation methods. The preheating of the exterior surface and/or the contact surface is sufficient to cause the photosensitive layer to become or maintain its tacky nature to attach to the sleeve, and to soften sufficiently to seal the adjacent ends together. In this embodiment, the cylindrical photosensitive element, in particular the photosensitive layer on the support, can be heated to a temperature less than the glass transition temperature of the photosensitive layer. It is desirable to additionally heat the cylindrical photosensitive element to the extent sufficient to fuse the adjacent ends under lamination. Because the photosensitive element was preheated, only a minimal additional heating of the photosensitive element may be needed to complete the bond and fuse the adjacent ends together under lamination.

The process includes laminating the photosensitive layer to the support to seal and fuse the ends together to form a continuous layer on the support. The term "laminating", (or lamination, laminated) refers to uniting layers of at least two materials together, that is, laminating attaches or joins the photosensitive layer to the sleeve support to become a unitary structure and form the cylindrically-shaped photosensitive element. The laminating roll contacts the exterior surface of the photosensitive layer and presses to laminate the layer onto the support. In some embodiments, the roll continues to rotate the sleeve (with the photosensitive layer) while the laminating roll contacts the photosensitive layer and seals and/or fuses the adjacent ends. This embodiment can also help to maintain the thickness uniformity of the photosensitive layer on the cylindrically-shaped support. In some embodiments, the laminating roll contacts the photosensitive layer in only the locale where the adjacent ends are sealing and/or fusing. In this embodiment, the base roll may only partially rotate or the laminating roll may be oriented to pressing contact in the locale of the adjacent ends. The laminating roll can have the same or a different impression setting from the impression setting used during contacting. In some embodiments, the laminating roll can have impression setting between 0 and 1 mm, and in other embodiments, the laminating roll can have an impression setting between 0 and 0.5mm, for laminating and fusing.

During laminating, the first end and the second end are sealing and/or fusing together to form a continuous layer of the photosensitive layer on the cylindrically-shaped support. Fusing is the blending of the adjacent ends together with the material in a plastic, i.e., softened, state. Fusing of the ends can occur with the heat residing in the sleeve and/or the photosensitive layer that was introduced during preheating. The sleeve and/or the photosensitive layer is heated to a temperature sufficient to effect softening of the layer at least at the ends and render the adjacent ends capable of fusing during laminating. The sleeve and/or layer is heated to a temperature such that the ends are softened and are capable of fusing in a short time and form the continuous layer. In some embodiments after laminating, the continuous layer has no visible or printable seam at a locale where the ends met, that is the ends have been sealed and fused. Fusing of the ends can be aided with additional heating after the photosensitive layer has contacted the sleeve. After laminating, fusing, and grinding the continuous layer has no visible or printable seam at a locale where the ends met. In some embodiments, the steps of contacting and laminating to seal and fuse the adjacent ends are conducted in the same device.

After the adjacent ends are fused to form the continuous seamless photosensitive layer on the sleeve support, the element can be cooled to room temperature, before removing the cylindrical photosensitive element from the base roll. The cylindrical photosensitive element has axial ends that may be trimmed to the desired length of the element.

Optionally, any nonuniformity in the thickness of the cylindrical photosensitive layer, particularly at the locale where the first and second ends fused, or surface disturbances can be removed by grinding the photosensitive layer to the desired thickness uniformity. Grinding with a grinding stone is a conventional method for removing excess polymeric material to provide desired thickness uniformity.

Optionally, other layers can be applied to an exterior surface of the cylindrically-shaped photosensitive element by the same inventive process or a different process as the photosensitive layer was secured to the sleeve support. Care must be taken for any process of applying additional layers to the exterior surface to operate at a temperature no higher than the highest temperature used in the present process to make the cylindrically-shaped photosensitive element. An example of an additional layer applied to the exterior surface of the element can be an actinic radiation opaque layer suitable for forming an in-situ mask. The actinic radiation opaque layer can be applied to the exterior surface by any means, for example, coating of cylindrical forms as disclosed by Bode et al. in U.S. Patent 6,531,184 and Michels et al. in US Publication No. 2001/0012599 A1.

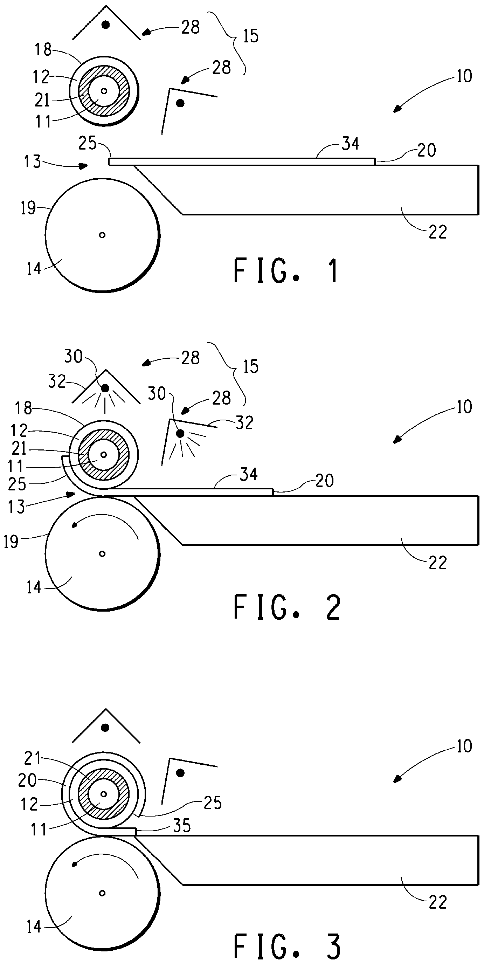

The present process for preparing a cylindrically shaped photosensitive element is conducted in a device that accommodates the cylindrical support and the resulting cylindrically shaped element. One embodiment of a device 10 for making the cylindrically shaped photosensitive element is shown in Figures 1 through 3. The device 10 includes a base roll 11 for supporting the cylindrical (sleeve) support 12, a laminating roll 14 adjacent the base roll 11 and forming a nip 13 with the base roll (or the support on the base roll), and a means for preheating 15 the exterior surface 18 of the support 12 and/or the contact surface of the photosensitive layer 20. In the invention, the base roll 11 includes a compliant layer 21 as the outer surface of the base roll. The sleeve support 12 is mounted onto the base roll 11 so that the interior surface of the support contacts the compliant layer 21 of the base roll. The position of the base roll 11 and/or the laminating roll 14 can be adjusted relative to each other and thus change the distance between the exterior surface 18 of the support 12 (or base roll) and an outer surface 19 of the laminating roll 14 at the nip 13. The capability to adjust the distance between surfaces at the nip 14 accommodates making elements with photosensitive layers of different thickness and with sleeve supports of different wall thickness.

Figure 1 is one embodiment of the device 10 showing one embodiment of a step of the present process that includes supporting a cylindrically-shaped support 12 on the base roll 11 such that the interior surface of the support 12 contacts the compliant layer 21 of the outer surface of the base roll 11; and providing the layer of the photosensitive composition in the nip 13 between the laminating roll 14 and the base roller 13. A photosensitive layer 20 resides on a movable table 22 with a first end 25 (or a leading edge) of the photosensitive layer positioned between the base roll 11 holding the cylindrical support sleeve 12 and the laminating roll 14. The moveable table can be considered one embodiment of a means for positioning the photosensitive element to the sleeve 12. The base roll 11 is a means for supporting the sleeve 12, selected from a shaft, a drum, a mandrel. The distance from the exterior surface 18 of the sleeve 12 to the outer surface 19 of the laminating roll 14 at the nip 13 initially is greater than the total thickness of the photosensitive layer 20. The photosensitive layer 20 is positioned so that the leading edge 25 of the element is first to enter the nip 13. The moveable table 22 which is adjacent the base roll 11 and the laminating roll 14 may be used to hold and help position the layer 20. The moveable table 22 moves in a first direction parallel to an axis of the base roll 11 and in a second direction perpendicular to the axis of the base roll 11 to correctly locate the photosensitive layer 20 between the sleeve support 12 and the laminating roll 14. The laminating roll 14 and/or the base roll 11 can be moved to capture the first end 25 of the photosensitive layer 20 into the nip 13 between the laminating roll 14 and sleeve support 12.

Figure 2 is one embodiment of a step of the present process showing heating the support 12 and the photosensitive layer 20. In the embodiment shown, a means for heating 15 preheats the support 12 and the photosensitive layer 20. One embodiment of the means for preheating 15 the exterior surface 18 of the support 12 and a contact surface 24 of the photosensitive layer 20 is shown as radiant heaters 28, each comprising at least one tubular infrared heating bulb 30, that is mounted in end supports (not shown) connected to a frame of the device 10, and provided with electrical connection to the bulb. Adjacent the side of the bulb 30 is a reflector 32 that acts to focus and direct the infrared radiation toward the exterior surface 18 of the sleeve support 12 and the contact surface 34 of the photosensitive layer. Such a heater 28 having an infrared heating bulb 30 with end supports and a reflector 32 can be obtained from Heraeus Noblelight GmbH, (Hanau, Germany). The base roll 11 rotates, and thereby rotates the sleeve support 12, so that the entire exterior surface 18 of the sleeve is heated before contact of the photosensitive layer 20 to the sleeve. As the photosensitive layer 20 traverses the table 22, the contact surface 34 of the layer is heated before contact with the sleeve.

In an alternate embodiment for the means for preheating 15, a single radiant heater 28 can be used to preheat the sleeve 12 and/or the photosensitive layer 20. The heater 28, including the reflector 32, can be mounted on the device 10 such that the heater rotates it s position to accommodate preheating the sleeve 12 and/or the photosensitive layer 20.

Figure 2 also shows an embodiment of contacting the contact surface 34 of the photosensitive layer 20 to the exterior surface 18 of the sleeve support 12, particularly contacting a leading portion of the photosensitive layer to the sleeve. The base roll 11 and/or the laminating roll 14 can include means for moving relative to the other (not shown). The leading edge 25 of the photosensitive layer 20 and the sleeve support located at the nip 13 have been preheated before the base roll 11 and the laminating roll 14 capture the leading edge 25 of the photosensitive layer 20 in the nip 13. The photosensitive layer 20 and the sleeve 12 not yet contacting each other, i.e., noncontacting portions of the layer and the sleeve, may continue to be preheated by the heaters 28. At least the laminating roll 14 includes a means for pressing (not shown) the roll against the photosensitive layer 20 (that is contacting the sleeve support 12). It is well within the skill of those in the art to provide a suitable embodiment for the means for pressing the laminating roll 14, examples of which include, but are not limited to, tensioning springs, actuating cylinders, rotation-to-translation mechanisms to maintain the displacement gap at the nip with impression setting, and translation-to-translation mechanisms to maintain the displacement gap at the nip with impression setting.

Figures 2 and 3 depict an embodiment of a step of the present process showing contacting the photosensitive layer onto the support. The base roll 11 is rotating and thereby rotating the support 12 on the compliant layer 21 to mount and attach the photosensitive layer 20 to the exterior surface 18 of the support. The photosensitive layer 20 may include a coversheet or a sheet support (not shown) on the side opposite the contact surface 34 of the layer. At the nip 13, the contact surface 34 of the photosensitive layer 20 contacts the exterior surface 18 of the sleeve support 12 and attaches to the support. The laminating roll 14 pressing the photosensitive layer 20 against the sleeve support 12 causes the compliant layer 21 underlying the support 12 to yield elastically to the pressing force which provides good contact of the sleeve support to the photosensitive layer at the nip. The good contact between the sleeve support 12 and the photosensitive layer 20 allows air to escape and/or avoids trapping air from between the photosensitive layer and the sleeve support. The photosensitive layer 20 travels with the support as it is rotated on the base roll 11. As the base roll 11 completes or just passes its full rotation, the first end 25 of the photosensitive layer 20 is brought at least adjacent to a second end 35 of the layer, forming a cylindrical but somewhat discontinuous layer of photosensitive material on the support 12. The good contact between the sleeve support 12 and the photosensitive layer 21_provided by the compliant layer 21 underlying the support sleeve is particularly advantageous when the second end 35 is brought adjacent to the first end 25 of the layer 20, since air is less likely to become trapped between or at the ends when joined.

The base roll 11 continues rotating the support 12 with the photosensitive layer 20 as the laminating roll 14 presses in contact for a time to laminate the layer to the support and fuse the adjacent ends. Fusing the ends of the photosensitive layer 20 forms the continuous layer of the photosensitive material on the support. In one embodiment of laminating, the laminating roll 14 remains in contact with the photosensitive layer 20 and the base roll 11 continues rotating the support 12 to maintain the thickness uniformity of the layer and to fuse the adjacent.

A device for making cylindrically-shaped photosensitive elements can be derived from apparatuses for mounting flexographic printing plates onto a printing cylinder which have been disclosed, for example, in EP 0 329 228 A1 and U.S. Patents 5,488,781, 4,872,407, and 4,520,389. Further, a commercial apparatus for mounting flexographic printing plates onto printing cylinders is available as CYREL^{®} Microflex mounting and proofing system by DuPont (Wilmington, DE). The flexographic printing plate which is mounted onto a print cylinder by a conventional mounting apparatus has already undergone the steps of imagewise exposure and treatment to form the relief printing surface on the plate, and therefore does not have address some of the concerns associated with making cylindrically shaped photosensitive elements, such as forming the photosensitive layer into a cylinder and fusing adjacent ends. It is within the skill of one in the art to modify mounting apparatuses which are used to mount printing plates onto printing cylinders, according to the present description, to accommodate joining of raw, i.e., unexposed, photosensitive layer onto a support. In some embodiments, the steps of contacting and laminating to at least seal and optionally fuse the adjacent ends are conducted in the same device.

The present process has particular advantages since the process of making the cylindrical photosensitive element is facilitated by the presence of the compliant surface on the roll that supports the sleeve by simplifying the operational handling and applying of the photosensitive layer during the laminating step. Advantageously, the compliant surface on the roll supporting the sleeve also reduces or eliminates the creation of defects bubbles or entrapped air in and about a location where the adjacent ends are joined and fused. The present process can also provide for increased change-over from the preparation of one cylindrical photosensitive element to the next. The compliant surface can provide sufficient friction between the support sleeve and the base roll, such that the base roll itself can be undersized up to several millimeters in diameter without concern for slippage occurring between the sleeve and the base roll during lamination. The slightly undersized base roll allows for quick and easy removal of the cylindrically-shaped photosensitive element from the base roll without the need to wait for the element to cool down. Some embodiments of the present invention has an additional advantage in that an adhesive layer or tape is not needed between the sleeve and the photosensitive layer to facilitate the attachment of the photosensitive layer to the sleeve support. Preheating the exterior surface of the sleeve and/or the contact surface of the photosensitive layer, prior to contact of the photosensitive layer with the support, avoids the use of adhesive. This simplifies the process for making the cylindrically shaped photosensitive element by eliminating extra step of applying the adhesive material or tape. This also avoids the potential for defects, such as bubbles, streaks, etc. caused by the application of the adhesive.

### Photosensitive Composition

In one embodiment, the photosensitive element includes a layer of a photopolymerizable composition comprising an thermoplastic binder, at least one monomer, and a photoinitiator. The photosensitive layer may also be referred to herein as a photopolymerizable layer. As used herein, the term "photopolymerizable" is intended to encompass systems that are photopolymerizable, photocrosslinkable, or both. The photoinitiator has sensitivity to actinic radiation.

The photopolymerizable layer is a solid elastomeric layer formed of the composition comprising a thermoplastic binder, at least one monomer, and a photoinitiator. The photoinitiator has sensitivity to actinic radiation. Throughout this specification actinic radiation will include ultraviolet radiation and/or visible light. The solid layer of the photopolymerizable composition is treated with one or more solutions and/or heat to form a relief suitable for flexographic printing. As used herein, the term "solid" refers to the physical state of the layer which has a definite volume and shape and resists forces that tend to alter its volume or shape.

The thermoplastic binder can be a single polymer or mixture of polymers. The thermoplastic binder preferably is elastomeric. Binders include natural or synthetic polymers of conjugated diolefin hydrocarbons, including polyisoprene, 1,2-polybutadiene, 1,4-polybutadiene, butadiene/acrylonitrile, and diene/styrene thermoplastic-elastomeric block copolymers. Preferably, the thermoplastic binder is an elastomeric block copolymer of an A-B-A type block copolymer, where A represents a non-elastomeric block, preferably a vinyl polymer and most preferably polystyrene, and B represents an elastomeric block, preferably polybutadiene or polyisoprene. Preferred thermoplastic elastomeric binders are poly(styrene/isoprene/styrene) block copolymers and poly(styrene/butadiene/styrene) block copolymers. The non-elastomer to elastomer ratio of the A-B-A type block copolymers is preferably in the range of from 10:90 to 35:65. The thermoplastic binder can be soluble, swellable, or dispersible in aqueous, semi-aqueous, water, or organic solvent washout solutions. Elastomeric binders which can be washed out by treating in aqueous or semi-aqueous developers have been disclosed by Proskow, in U.S. Patent 4,177,074; Proskow in U.S. Patent 4,431,723; Worns in U.S. Patent 4,517,279; Suzuki et al. in U.S. 5,679,485; Suzuki et al. in U.S. 5,830,621; and Sakurai et al. in U.S. 5,863,704. The block copolymers discussed in Chen, U.S. Patent 4,323,636; Heinz et al., U.S. Patent 4,430,417; and Toda et al., U.S. Patent 4,045,231 can be washed out by treating in organic solvent solutions. Generally, the thermoplastic binders which are suitable for washout development are also suitable for use in thermal treating wherein the unpolymerized areas of the photopolymerizable layer soften, melt, or flow upon heating. The binder is present in an amount of at least 50 % by weight of the photosensitive composition.

The term binder, as used herein, encompasses core shell microgels and blends of microgels and preformed macromolecular polymers, such as those disclosed in Fryd et al., U.S. Patent 4,956,252 and Quinn et al., U.S. Patent 5,707,773.

Other suitable photosensitive elastomers that may be used include polyurethane elastomers. An example of a suitable polyurethane elastomer is the reaction product of (i) an organic diisocyanate, (ii) at least one chain extending agent having at least two free hydrogen groups capable of polymerizing with isocyanate groups and having at least one ethylenically unsaturated addition polymerizable group per molecule, and (iii) an organic polyol with a minimum molecular weight of 500 and at least two free hydrogen containing groups capable of polymerizing with isocyanate groups. For a more complete description of some of these materials see U.S. Pat. No. 5,015,556.

The photopolymerizable composition contains at least one compound capable of addition polymerization that is compatible with the binder to the extent that a clear, non-cloudy photosensitive layer is produced. The at least one compound capable of addition polymerization may also be referred to as a monomer and can be a single monomer or mixture of monomers. Monomers that can be used in the photopolymerizable composition are well known in the art and include, but are not limited to, addition-polymerization ethylenically unsaturated compounds with at least one terminal ethylenic group. Examples of suitable monomers include, but are not limited to, acrylate and methacrylate mono-esters of alcohols and polyols, and acrylate and methacrylate poly-esters of alcohols and polyols. Examples of alcohols and polyols include alkanols; alkylene glycols; trimethylol propane; pentaerythritol; dipentaerythritol; polyacrylol oligomers, and the like. A mixture of monofunctional and multifunctional acrylates or methacrylates may be used. Other examples of suitable monomers include acrylate and methacrylate derivatives of isocyanates, esters, epoxides and the like. Monomers can be appropriately selected by one skilled in the art to provide elastomeric property to the photopolymerizable composition. Examples of elastomeric monomers include, but are not limited to, acrylated liquid polyisoprenes, acrylated liquid butadienes, liquid polyisoprenes with high vinyl content, and liquid polybutadienes with high vinyl content, (that is, content of 1-2 vinyl groups is greater than 20% by weight). Further examples of monomers can be found in Chen U.S. Patent No. 4,323,636; Fryd et al., U.S. Patent No. 4,753,865; Fryd et al., U.S. Patent No. 4,726,877 and Feinberg et al., U.S. Patent No. 4,894,315. The compound capable of addition polymerization (monomer) is present in at least an amount of 5%, preferably 10 to 20%, by weight of the elastomeric composition.

The photoinitiator can be any single compound or combination of compounds which is sensitive to actinic radiation, generating free radicals which initiate the polymerization of the monomer or monomers without excessive termination. The photoinitiator is activated by the actinic radiation, having sensitivity to the radiation in accordance with its absorption spectrum. The absorption spectrum of the photoinitiator typically includes an absorption peak at a wavelength of maximum absorption to the actinic radiation. Photosensitive elements for use as flexographic printing forms that are sensitive to these particular UV sources typically use photoinitiators that absorb between 310-400 nm. Any of the known classes of photoinitiators, particularly free radical photoinitiators such as may be used. Alternatively, the photoinitiator may be a mixture of compounds, one of which provides the free radicals when caused to do so by a sensitizer activated by radiation. In one embodiment, the initiator is sensitive to ultraviolet radiation. In another embodiment, the initiator is sensitive to visible radiation. Photoinitiators are generally present in amounts from 0.001 % to 10.0% based on the weight of the photopolymerizable composition.

The photopolymerizable composition can contain other additives depending on the final properties desired. Additional additives to the photopolymerizable composition include sensitizers, plasticizers, rheology modifiers, thermal polymerization inhibitors, colorants, processing aids, antioxidants, antiozonants, and fillers.

The thickness of the photosensitive layer can vary over a wide range depending upon the type of printing form desired, for example, from about 0.020 inches to about 0.250 inches or greater (about 0.05 cm to about 0.64 cm or greater). In some embodiments, the thickness of the photosensitive layer provided is greater than the thickness of the continuous photosensitive layer on the sleeve support.

The photopolymerizable layer itself can be prepared in many ways by admixing the binder, monomer, photoinitiator, and other ingredients. In some embodiments where the photosensitive layer originates from a photosensitive plate, the photopolymerizable mixture can be formed into a hot melt and then calendered to the desired thickness. An extruder can be used to perform the functions of melting, mixing, deaerating and filtering the composition. The extruded mixture can then be calendered between the support and a temporary coversheet. Alternatively, the photopolymerizable material can be placed between the support and the temporary coversheet in a mold. The layers of material are then pressed flat by the application of heat and/or pressure.

In one embodiment the cylindrically-shaped photosensitive element may include an infrared (IR)-sensitive layer on top of the photosensitive layer (or other layers if present). The IR-sensitive layer can form an integrated masking layer for the photosensitive element. The preferred IR-sensitive layer is opaque to actinic radiation that is, has an optical density of at least 1.5 ; can be imaged, preferably by ablating, with an infrared laser; and removable during treating, i.e., soluble or dispersible in a developer solution or during thermal development. The IR sensitive layer contains material having high absorption in the wavelength (infrared range between 750 and 20,000 nm, such as, for example, polysubstituted phthalocyanine compounds, cyanine dyes, merocyanine dyes, etc., inorganic pigments, such as, for example, carbon black, graphite, chromium dioxide, etc., or metals, such as aluminum, copper, etc. The quantity of infrared absorbing material is usually 0.1-40 % by weight, relative to the total weight of the layer. To achieve the desired optical density to block actinic radiation, the infrared-sensitive layer contains a material that prevents the transmission of actinic radiation. In some embodiments, the optical density can be between 2.0 and 3.0. In some embodiments, the optical density can be between 2.6 and 3.4. This actinic radiation blocking material can be the same or different than the infrared absorbing material, and can be, for example, dyes or pigments, and in particular the aforesaid inorganic pigments. The quantity of this material is usually 1-70% by weight relative to the total weight of the layer. The infrared-sensitive layer optionally includes a polymeric binder, such as, for example, nitrocellulose, homopolymers or copolymers of acrylates, methacrylates and styrenes, polyamides, polyvinyl alcohols, etc. Other auxiliary agents, such as plasticizers, coating aids, etc. are possible. The infrared-sensitive layer is usually prepared by coating a solution or dispersion of the aforesaid components as a layer on the photosensitive layer, and subsequently drying it. The thickness of the infrared-sensitive layer is usually 2 nm to 50 µm, preferably 4 nm to 40 µm. These infrared-sensitive layers and their preparation are described in detail, for example in WO 94/03838 and WO 94/3839. The infrared sensitive material to may be applied by any suitable method to the exterior surface of the photosensitive layer, preferably to form a layer, and includes for example, immersion, spraying, jetting, and coating. Examples of suitable methods of coating include spin coating, dip coating, slot coating, roller coating, and doctor blading.

The cylindrically-shaped photosensitive element is converted to the cylindrically-shaped printing form by undergoing conventional steps of exposing (including imagewise exposure and optionally backflash exposure) and treating to form a relief surface on the printing form suitable for flexographic printing.

The exposure process usually comprises a back exposure and a front image-wise exposure, although the former is not strictly necessary. The back exposure or "backflash" can take place before, after or during image-wise exposure. Backflash prior to image-wise exposure is generally preferred.

Upon imagewise exposure, the radiation-exposed areas of the photosensitive layer are converted to the insoluble state with no significant polymerization or crosslinking taking place in the unexposed areas of the layer. Any conventional source of actinic radiation can be used for this exposure. Examples of suitable radiation sources include xenon lamps, mercury vapor lamps, carbon arcs, argon glow lamps, fluorescent lamps with fluorescent materials emitting UV radiation and electron flash units, and photographic flood lamps. Typically, a mercury vapor arc or a sunlamp can be used at a distance of about 1.5 to about 60 inches (about 3.8 to about 153 cm) from the photosensitive element. These radiation sources generally emit long-wave UV radiation between 310-400 nm. The exposure time may vary from a few seconds to minutes, depending upon the intensity and spectral energy distribution of the radiation, its distance from the photosensitive element, and the nature and amount of the photopolymerizable material.

Imagewise exposure can be carried out by exposing the photosensitive element through an image-bearing photomask. The photomask can be a separate film, i.e., an image-bearing transparency or phototool, such as a silver halide film; or the photomask can be integrated with the photosensitive element as described above. In the case in which the photomask is a separate film, the optional cover sheet is usually stripped before imagewise exposure leaving the release layer on the photosensitive element. The photomask is brought into close contact with the release layer of the photosensitive element by the usual vacuum processes, e.g., by use of a common vacuum frame. Thus a substantially uniform and complete contact between the photosensitive element and the photomask can be achieved in acceptable time.

It is preferred to form the integrated photomask on the cylindrical photosensitive element. In a particularly preferred embodiment, the photosensitive element includes the IR-sensitive layer which becomes the integrated photomask. The IR-sensitive layer is imagewise exposed to IR laser radiation to form the photomask on the photosensitive element. The infrared laser exposure can be carried out using various types of infrared lasers, which emit in the range 750 to 20,000 nm. Infrared lasers including, diode lasers emitting in the range 780 to 2,000 nm and Nd:YAG lasers emitting at 1064 nm are preferred. In so-called digital imaging, the radiation opaque layer is exposed imagewise to infrared laser radiation to form the image on or disposed above the photopolymerizable layer, i.e., the in-situ mask. The infrared laser radiation can selectively remove, e.g., ablate or vaporize, the infrared sensitive layer (i.e., radiation opaque layer) from the photopolymerizable layer, as disclosed by Fan in U.S. Patents 5,262,275 and 5,719,009; and Fan in EP 0 741 330 B1. The integrated photomask remains on the photosensitive element for subsequent steps of UV pre-exposure, imagewise main exposure to actinic radiation and development.

In an alternate embodiment of digital method of mask formation, the photosensitive element will not initially include an infrared sensitive layer. In this case the infrared sensitive layer is the same as or substantially the same as the infrared sensitive layer included with the photosensitive layer as described above. A separate element bearing the infrared sensitive layer will form an assemblage with the photosensitive element such that the infrared sensitive layer is adjacent the surface of the photosensitive element opposite the support, which is typically the photopolymerizable layer. The separate element may include one or more other layers, such as ejection layers or heating layers, to aid in the digital exposure process. The assemblage is exposed imagewise with infrared laser radiation to selectively transfer the infrared sensitive layer and form the image on or disposed above the photopolymerizable layer as disclosed by Fan et al. in U.S. Patent 5,607,814; and Blanchett in U.S. Patents 5,766,819; 5,840,463; and EP 0 891 877 A. Only the portions of the infrared sensitive layer which were transferred will reside on the photosensitive element forming the *in situ* mask.

Further, the mask image may be created on a separate carrier and then transferred by application of heat and/or pressure to the surface of the photopolymerizable layer opposite the support. The photopolymerizable layer is typically tacky and will retain the transferred image. The separate carrier can then be removed from the element prior to the pre-exposure and/or the imagewise exposure. The separate carrier may have an infrared sensitive layer that is imagewise exposed to laser radiation to selectively remove the material and form the image. An example of this type of carrier is LaserMask^{®} imaging film by Rexam, Inc.

It is also contemplated that digital mask formation can be accomplished by imagewise application of the radiation opaque material in the form of inkjet inks. Imagewise application of an ink-jet ink can be directly on the photopolymerizable layer or disposed above the photopolymerizable layer of the photosensitive element.

Following overall exposure to UV radiation through the image-bearing mask, the photosensitive element is treated to remove unpolymerized areas in the photopolymerizable layer and thereby form a relief image. Treatment of the photosensitive printing element can include (1) "wet" development wherein the photopolymerizable layer is contacted with a suitable developer solution to washout unpolymerized areas and (2) "dry" development wherein the photopolymerizable layer is heated to a development temperature which causes the unpolymerized areas to melt or soften and is contacted with an absorbant material to wick away the unpolymerized material. Dry development may also be called thermal development. Wet development is usually carried out at about room temperature. The developer solution can include an organic solvent, an aqueous or a semi-aqueous solution, or water. The choice of the developer solution will depend primarily on the chemical nature of the photopolymerizable composition to be removed. A suitable organic solvent developer includes an aromatic or an aliphatic hydrocarbon, an aliphatic or an aromatic halohydrocarbon solvent, or a mixture of such solvents with a suitable alcohol. Other organic solvent developers have been disclosed in published German Application DE 38 28 551. A suitable semi-aqueous developer can contain water and a water miscible organic solvent and an alkaline material. A suitable aqueous developer can contain water and an alkaline material. Other suitable aqueous developer solution combinations are described in U.S. Patent No. 3,796,602.

Development time can vary, but it is preferably in the range of about 2 to about 25 minutes. The developer solution can be applied in any convenient manner, including immersion, spraying, and brush or roller application. Brushing aids can be used to remove the unpolymerized portions of the photosensitive printing element. Washout can be carried out in an automatic processing unit which uses developer and mechanical brushing action to remove the unexposed portions of the resulting flexographic printing plate, leaving a relief constituting the exposed image and the floor.

Following treatment by developing in solution, the flexographic printing forms are generally blotted or wiped dry, and then more fully dried in a forced air or infrared oven. Drying times and temperatures may vary, however, typically the plate can be dried for about 60 minutes to about 120 minutes at about 60°C. High temperatures are not recommended because the support can shrink, and this can cause registration problems.

In thermal development, the photopolymerizable layer can be heated to a development temperature typically between about 40°C and 200°C which causes the unpolymerized areas to liquefy, that is, to melt or flow. The photopolymerizable layer can then be contacted with a development material to remove the unpolymerized photopolymerizable composition. The polymerized areas of the photopolymerizable layer have a higher melting temperature than the unpolymerized areas and therefore do not melt at the development temperatures (see U.S. 5,215,859 and WO 98/13730). Apparatus suitable for thermal development of photosensitive printing elements is disclosed in U.S. 5,279,697 and U.S. 6,797,454.

In another alternate embodiment the imaging element may be suitably reinforced and then imagewise exposed to laser radiation to engrave or remove the reinforced layer in depth imagewise. U.S. Patents No. 5,798,202; U.S. 5,804,353; and U.S. 6,757,216 B2 disclose suitable processes for making a flexographic printing plate by laser engraving a reinforced elastomeric layer on a flexible support. The processes disclosed in U.S. Patents No. 5,798,202 and 5,804,353 involve reinforcing and laser engraving a single-layer, or one or more layers of a multi-layer, of a flexographic printing element comprised of a reinforced elastomeric layer on a flexible support. The elastomeric layer is reinforced mechanically, or thermochemically, or photochemically or combinations thereof. Mechanical reinforcement is provided by incorporating reinforcing agents, such as finely divided particulate material, into the elastomeric layer. Photochemical reinforcement is accomplished by incorporating photohardenable materials into the elastomeric layer and exposing the layer to actinic radiation. Photohardenable materials include photocrosslinkable and photopolymerizable systems having a photoinitiator or photoinitiator system.

The flexographic printing forms made using the cylindrically-shaped photosensitive element can be uniformly post-exposed to ensure that the photopolymerization process is complete and that the printing form will remain stable during printing and storage. This post-exposure step can utilize the same radiation source as the main exposure.

Detackification is an optional post-development treatment which can be applied if the surface of the flexographic printing plate is still tacky, such tackiness not generally being removed in post-exposure. Tackiness can be eliminated by methods well known in the art, such as treatment with bromine or chlorine solutions, and by exposure to radiation sources having a wavelength not longer than 300 nm.

## Claims

1. A process for making a cylindrically-shaped photosensitive element for use as a printing form, comprising:
a) mounting a cylindrically-shaped support (12) having an exterior surface (18) and an interior surface onto a roll (11) having an outer surface (21), the interior surface of the support (12) contacting the outer surface (21) of the roll (11), wherein the roll (11) is selected from a shaft, a drum or a mandrel and wherein the outer surface (21) of the roll (11) is compliant;
b) providing a photosensitive layer (20) comprising a thermoplastic binder, monomer and photoinitiator, the layer having a first end (25) and a second end (35) opposite the first end (25) joined by a contact surface (34);
c) contacting the contact surface (34) of the photosensitive layer (20) to the exterior surface (18) of the support (12) by wrapping the photosensitive layer (20) around the support (12) to bring the second end (35) adjacent the first end (25);
d) laminating the photosensitive layer (20) onto the support (12) and sealing the ends (25, 35) together to form a continuous layer (20) on the support (12); and
e) heating the photosensitive layer (20), or the support (12), or both the photosensitive layer (20) and the support (12);
**characterised in that** the photosensitive layer (20) is laminated onto the support (12) by using a laminating roll (14) to form a nip with the support (12) and the photosensitive layer (20) therebetween and the process further comprises the step of removing the resulting cylindrically-shaped photosensitive element from the roll (11).

2. The process of Claim 1 wherein the compliant outer surface (21) has a Shore A durometer of between about 40 and about 70.

3. The process of Claim 1 wherein the second end (35) is adjacent the first end (25) such that the second end (35) abuts the first end (25).

4. The process of Claim 1 wherein the second end (35) is adjacent the first end (25) such that a gap is formed between the first end (25) and the second end (35).

5. The process of Claim 4 wherein the photosensitive layer (20) has a thickness and the gap is less than or equal to about half of the thickness of the photosensitive layer (20).

6. The process of Claim 1 wherein prior to the contacting step, further comprising trimming the first end (25) and/or the second end (35) to abut or form a gap with the other end.

7. The process of Claim 1 wherein the heating step occurs prior to the contacting step, after the contacting step, or a combination of both.

8. The process of Claim 1 wherein the heating step is performed prior to the contacting step and is selected from the group consisting of 1) preheating the exterior surface (18) of the support (12) to a temperature greater than 39°C; 2) preheating the contact surface (34) of the photosensitive layer (20) to a temperature less than its glass transition temperature; and a combination of 1) and 2).

9. The process of Claim 1 further comprising fusing the ends (25, 35) together during laminating.

10. The process of Claim 1 further comprising, after the contacting step, heating the photosensitive layer (20) to a temperature sufficient for fusing the sealing ends (25, 35) together during laminating.

11. The process of Claim 1 further comprising grinding a surface (34) of the photosensitive layer (20) opposite the support (12) after the laminating step.

12. The process of Claim 1 wherein the support (12) is transparent to actinic radiation, the process further comprising after step e) exposing the element to actinic radiation through the support (12).

13. The process of Claim 1 wherein the laminating step comprises rotating the support (12) having the photosensitive layer (20) and contacting an exterior surface (34) of the photosensitive layer (20) opposite the support (12) with the laminating roll (14).

14. The process of Claim 13 wherein the laminating roll (14) is pressing the photosensitive layer (20) with an impression setting of 0 to 1 mm.

## Patentansprüche

1. Verfahren zur Herstellung eines zylinderförmigen lichtempfindlichen Elements zu Verwendung als Druckform, folgende Schritte beinhaltend:
a) Montage einer zylinderförmigen Halterung (12), besitzend eine äußere Fläche (18) und eine innere Fläche, an einer Rolle (11), welche eine äußere Fläche (21) besitzt, wobei die innere Fläche der Halterung (12) in Kontakt mit der äußeren Fläche (21) der Rolle (11) steht, wobei die Rolle (11) aus einem Schaft, einer Trommel oder einem Dorn ausgewählt ist und wobei die äußere Fläche (21) der Rolle (11) nachgiebig ist;
b) Bereitstellung einer lichtempfindlichen Schicht (20), beinhaltend ein thermoplastisches Bindemittel, ein Monomer, und einen Fotoinitiator, wobei die Schicht ein erstes Ende (25) und ein zweites Ende (35) gegenüber dem ersten Ende (25) besitzt, welche durch eine Kontaktfläche (34) verbunden sind;
c) Herstellung von Kontakt zwischen der Kontaktfläche (34) der lichtempfindlichen Schicht (20) und der äußeren Fläche (18) der Halterung (12) durch Umschlagen der lichtempfindlichen Schicht (20) um die Halterung (12), um das zweite Ende (35) angrenzend am ersten Ende (25) zu positionieren;
d) Laminieren der lichtempfindlichen Schicht (20) auf die Halterung (12) und Verschweißen der Enden (25, 35) miteinander, um eine durchgängige Schicht (20) auf der Halterung (12) zu bilden; und
e) Erwärmen der lichtempfindlichen Schicht (20) oder der Halterung (12), oder sowohl der lichtempfindlichen Schicht (20) als auch der Halterung (12);
**dadurch gekennzeichnet, dass** die lichtempfindliche Schicht (20) auf die Halterung (12) durch Verwendung einer Laminierrolle (14) laminiert wird, um eine Berührungslinie der Halterung (12) und der lichtempfindlichen Schicht (20) miteinander zu bilden, und das Verfahren zudem den Schritt der Beseitigung des resultierenden zylinderförmigen lichtempfindlichen Elements von der Rolle (11) beinhaltet.

2. Verfahren nach Anspruch 1, bei welchem die nachgiebige äußere Fläche (21) eine Shore A-Härte zwischen etwa 40 und etwa 70 besitzt.

3. Verfahren nach Anspruch 1, bei welchem das zweite Ende (35) so an das erste Ende (25) angrenzt, dass das zweite Ende (35) an das erste Ende (25) anstößt.

4. Verfahren nach Anspruch 1, bei welchem das zweite Ende (35) so an das erste Ende (25) angrenzt, dass ein Spalt zwischen dem ersten Ende (25) und dem zweiten Ende (35) gebildet wird.

5. Verfahren nach Anspruch 4, bei welchem die lichtempfindliche Schicht (20) eine Dicke besitzt und der Spalt kleiner als die oder gleich etwa der Hälfte der Dicke der lichtempfindlichen Schicht (20) ist.

6. Verfahren nach Anspruch 1, zusätzlich beinhaltend, vor dem Schritt der Kontaktherstellung, den Zuschnitt des ersten Endes (25) und/oder des zweiten Endes (35) zwecks Anordnung Stoß an Stoß oder Bildung eines Spalts mit dem anderen Ende.

7. Verfahren nach Anspruch 1, bei welchem der Schritt des Erwärmens vor dem Schritt der Kontaktherstellung, nach dem Schritt der Kontaktherstellung, oder als eine Kombination aus beiden erfolgt.

8. Verfahren nach Anspruch 1, bei welchem der Schritt des Erwärmens vor dem Schritt der Kontaktherstellung erfolgt, und aus der Gruppe ausgewählt wird, bestehend aus 1) Vorwärmen der äußeren Fläche (18) der Halterung (12) auf eine Temperatur über 39°C; 2) Vorwärmen der Kontaktfläche (34) der lichtempfindlichen Schicht (20) auf eine Temperatur unterhalb ihrer Glasübergangstemperatur; und einer Kombination aus 1) und 2).

9. Verfahren nach Anspruch 1, zudem beinhaltend das Verschmelzen der Enden (25, 35) miteinander beim Laminiervorgang.

10. Verfahren nach Anspruch 1, zudem beinhaltend, nach dem Schritt der Kontaktherstellung, eine Erwärmung der lichtempfindlichen Schicht (20) auf eine Temperatur, die ausreicht, um die verschweißenden Enden (25, 35) beim Laminiervorgang miteinander zu verschmelzen.

11. Verfahren nach Anspruch 1, zudem beinhaltend das Reiben einer Fläche (34) der lichtempfindlichen Schicht (20), die sich auf der der Halterung (12) abgewandten Seite befindet, nach dem Schritt des Laminierens.

12. Verfahren nach Anspruch 1, bei welchem die Halterung (12) transparent gegenüber aktinischer Strahlung ist, wobei das Verfahren zudem nach Schritt e) die Exposition des Elementes gegenüber aktinischer Strahlung durch die Halterung (12) beinhaltet.

13. Verfahren nach Anspruch 1, bei welchem der Schritt des Laminierens eine Rotation der mit der lichtempfindlichen Schicht (20) versehenen Halterung (12) und eine Kontaktherstellung zwischen einer äußeren Fläche (34) der lichtempfindlichen Schicht (20) auf der der Halterung (12) abgewandten Seite und der Laminierrolle (14) beinhaltet.

14. Verfahren nach Anspruch 13, bei welchem die Laminierrolle (14) die lichtempfindliche Schicht (20) mit einer Druckeinstellung von 0 bis 1 mm andrückt.

## Revendications

1. Procédé de fabrication d'un élément photosensible de forme cylindrique pour une utilisation en tant que forme d'impression, comprenant les étapes consistant à :
a) monter un support (12) de forme cylindrique possédant une surface extérieure (18) et une surface intérieure sur un rouleau (11) possédant une surface extérieure (21), la surface intérieure du support (12) étant en contact avec la surface extérieure (21) du rouleau (11), ledit rouleau (11) étant choisi parmi un arbre, un tambour ou un mandrin et ladite surface extérieure (21) du rouleau (11) étant souple ;
b) fournir une couche photosensible (20) comprenant un liant thermoplastique, un monomère et un photoamorceur, la couche présentant une première extrémité (25) et une seconde extrémité (35), opposée à la première extrémité (25), jointes par une surface de contact (34) ;
c) mettre en contact la surface de contact (34) de la couche photosensible (20) et la surface extérieure (18) du support (12) en enveloppant la couche photosensible (20) autour du support (12), pour amener la seconde extrémité (35) à être adjacente à la première extrémité (25) ;
d) laminer la couche photosensible (20) sur le support (12) et souder les extrémités (25, 35) l'une à l'autre afin de former une couche continue (20) sur le support (12) ; et
e) chauffer la couche photosensible (20) ou le support (12), ou bien la couche photosensible (20) et le support (12) ;
**caractérisé en ce que** la couche photosensible (20) est laminée sur le support (12) au moyen d'un rouleau de lamination (14) pour former une ligne de contact entre le support (12) et la couche photosensible (20), le procédé comprenant en outre l'étape consistant à retirer du rouleau (11) l'élément photosensible de forme cylindrique résultant.

2. Procédé selon la revendication 1, dans lequel la surface extérieure (21) souple (21) a une dureté Shore A comprise entre environ 40 et environ 70.

3. Procédé selon la revendication 1, dans lequel la seconde extrémité (35) est adjacente à la première extrémité (25) de sorte que la seconde extrémité (35) est en aboutement contre la première extrémité (25).

4. Procédé selon la revendication 1, dans lequel la seconde extrémité (35) est adjacente à la première extrémité (25) de sorte qu'un espace est formé entre la première extrémité (25) et la seconde extrémité (35).

5. Procédé selon la revendication 4, dans lequel la couche photosensible (20) présente une certaine épaisseur et l'espace est inférieur ou égal à environ la moitié de l'épaisseur de la couche photosensible (20).

6. Procédé selon la revendication 1, comprenant en outre, préalablement à l'étape de mise en contact, la découpe de la première extrémité (25) et/ou de la seconde extrémité (35) pour permettre leur aboutement ou la formation d'un espace avec l'autre extrémité.

7. Procédé selon la revendication 1, dans lequel l'étape de chauffage a lieu avant l'étape de mise en contact et/ou après l'étape de mise en contact.

8. Procédé selon la revendication 1, dans lequel l'étape de chauffage s'effectue préalablement à l'étape de mise en contact et est choisie dans le groupe constitué par 1) le préchauffage de la surface extérieure (18) du support (12) à une température supérieure à 39 °C ; 2) le préchauffage de la surface de contact (34) de la couche photosensible (20) à une température inférieure à sa température de transition vitreuse ; et une combinaison des possibilités 1) et 2).

9. Procédé selon la revendication 1, comprenant en outre la fusion des extrémités (25, 35) l'une à l'autre au cours de la lamination.

10. Procédé selon la revendication 1, comprenant en outre, après l'étape de mise en contact, le chauffage de la couche photosensible (20) à une température suffisante pour fusionner l'une à l'autre les extrémités soudantes (25, 35) pendant la lamination.

11. Procédé selon la revendication 1, comprenant en outre le meulage d'une surface (34) de la couche photosensible (20) opposée au support (12) après l'étape de lamination.

12. Procédé selon la revendication 1, dans lequel le support (12) est transparent aux rayonnements actiniques, le procédé comprenant en outre, après l'étape e), l'exposition de l'élément à des rayonnements actiniques à travers le support (12).

13. Procédé selon la revendication 1, dans lequel l'étape de lamination comprend la rotation du support (12) pourvu de la couche photosensible (20) et la mise en contact d'une surface extérieure (34) de la couche photosensible (20) opposée au support (12) avec le rouleau d'application (14).

14. Procédé selon la revendication 13, dans lequel le rouleau de lamination (14) presse la couche photosensible (20) avec un réglage de pression de 0 à 1 mm.
